# FASCICULE DE BREVET EUROPEEN

(11) **EP 1 249 814 B1**
(45) Date de publication et mention de la délivrance du brevet: **14.07.2004**
(21) Numéro de dépôt: 02290328.0
(22) Date de dépôt: 11.02.2002
(51) Int. Cl.: G08G 5/00, H03J 5/00, H03J 1/04

(54) **Dispositif de commande d'un système de communication d'un aéronef**
Kommunikationssystemsteuerungsvorrichtung für ein Flugzeug
Communication system control device for a plane

(30) Priorité: 27.02.2001 FR 0102634
(43) Date de publication de la demande: 16.10.2002
(73) Titulaire: AIRBUS FRANCE, 31060 Toulouse (FR)
(72) Inventeur: Gouillou, Jérôme, 31000 Toulouse (FR)
(74) Mandataire: Hauer, Bernard

(56) Documents cités:
- WO-A-96/27949
- DE-A- 4 442 413
- US-A- 4 179 662
- US-A- 4 357 710

## Description

La présente invention concerne un dispositif de commande d'un système de communication d'un aéronef, notamment d'un avion de transport.

Dans le cadre de la présente invention, on entend par système de communication un ensemble d'équipements de communication usuels, permettant de mettre en oeuvre et de contrôler les communications audio à bord de l'aéronef. Ces communications audio sont, en particulier, toutes celles que les pilotes de l'aéronef peuvent avoir, en particulier avec le contrôle aérien (par l'intermédiaire de canaux VHF ["Very High Frequency" : canaux à très hautes fréquences] ou de canaux HF ["High Frequency" : canaux à hautes fréquences] par exemple), avec les compagnies aériennes (par l'intermédiaire d'une liaison téléphonique, par exemple sur le réseau "SATCOM"), etc..

Le document US 4 357 710 décrit un appareil de communication radio en émission et en réception pour un aéronef, ayant une pluralité de sélecteurs de canal radio.

Pour commander un tel système de communication (c'est-à-dire l'ensemble desdits équipements de communication), on utilise généralement trois dispositifs différents et séparés l'un de l'autre, qui sont complémentaires pour la commande, à savoir :
- un dispositif pour la sélection ou le réglage manuel des numéros de téléphone, via le système SATCOM par exemple, généralement à partir d'une arborescence de pages MCDU ("Multipurpose Control and Display Unit") ;
- un dispositif du type ACP ("Audio Control Panel") pour le mixage de plusieurs canaux de radiocommunication (VHF, HF, ...) en réception. Dans le cadre de la présente invention, on entend par mixage de canaux (ou de fréquences radioélectriques) le mélange de plusieurs canaux (ou fréquences radioélectriques) avec un réglage particulier du volume sonore de chacun de ces canaux (ou fréquences radioélectriques) permettant une écoute simultanée des canaux (ou fréquences radioélectriques) ainsi réglés. Ce dispositif ACP permet également à un opérateur de sélectionner le canal pour l'émission (un seul canal à la fois) ; et
- un dispositif de réglage de fréquences, du type RMP ("Radio Management Panel"), RCP ("Radio Control Panel") ou RTP ("Radio Tuning Panel"), pour régler les fréquences radioélectriques des différents canaux. Ce dispositif de réglage de fréquences comporte des moyens d'affichage permettant de présenter sur un écran de visualisation un canal de radiocommunication, et un seul, parmi les différents canaux qui sont activés, canal de radiocommunication qui peut être sélectionné par des boutons-poussoirs et pour lequel on peut modifier la fréquence radioélectrique.

Comme ledit dispositif de réglage de fréquences RMP, RCP ou RTP :
- est indépendant du dispositif ACP destiné au mixage et au réglage du volume sonore, ainsi qu'à la sélection du canal pour l'émission ; et
- affiche uniquement une fréquence radioélectrique qui est sélectionnée pour un canal particulier,
les opérateurs (pilote, copilote, ...) de l'aéronef, qui utilisent ces différents dispositifs ont parfois tendance à considérer que la fréquence qui est affichée sur l'écran de visualisation du dispositif RMP, RCP ou RTP est celle du canal d'émission, réglée par le dispositif ACP, alors que cette fréquence affichée peut en réalité correspondre à un autre canal.

Cette situation peut engendrer une perte de temps dans la mesure où l'équipage n'ayant pas réglé le canal escompté, il reste en contact avec le contrôleur aérien précédent, alors qu'il croît s'annoncer au nouveau contrôleur et amène donc le contrôleur à répéter son instruction de changement de fréquence.

De plus, l'utilisation usuelle de trois dispositifs différents et séparés, comme indiqué précédemment, peut monopoliser l'attention des pilotes au détriment d'autres tâches d'équipage, notamment le fait de devoir régler et activer une fréquence sur l'un des dispositifs et de devoir régler le volume sonore correspondant à cette fréquence sur un autre desdits dispositifs, ce qui peut être gênant notamment dans des situations de panne ou d'urgence.

Cette complexité est accrue par la présence de plusieurs exemplaires de chacun des trois dispositifs précités dans le poste de pilotage. Ainsi, par exemple sur les avions du type "AIRBUS", chacun des deux pilotes dispose d'un ensemble formé d'un dispositif ACP et d'un dispositif RMP. De plus, un troisième ensemble de ce type est agencé au niveau du plafond du poste de pilotage. En outre, le mixage des canaux pour la réception est réalisé de façon indépendante par chaque pilote, tandis que, pour les réglages (ou saisies) des fréquences et des numéros de téléphone, les actions effectuées par un pilote sur l'un desdits trois ensembles modifient également les réglages des deux autres ensembles, car chacun des différents canaux existants (VHF, HF, téléphone, ...) correspond à des équipements (émetteur, récepteur, ...) qui ne peuvent être réglés que sur une seule fréquence (ou un canal/numéro téléphonique) à un instant donné.

La présente invention concerne un dispositif de commande d'un système de communication permettant de remédier à ces inconvénients.

A cet effet, selon l'invention, ledit dispositif de commande d'un système de communication d'un aéronef contrôlant les communications audio d'au moins un opérateur dudit aéronef, notamment un avion de transport, ledit système de communication engendrant une communication en émission et en réception par l'intermédiaire de valeurs de communication activables (à savoir des fréquences radioélectriques et/ou des numéros de téléphone) de canaux de communication particuliers (à savoir des canaux de radiocommunication et/ou des canaux de téléphone), ledit dispositif de commande comportant un boîtier qui est muni :
- de moyens d'affichage pour présenter sur au moins un écran de visualisation au moins l'une desdites valeurs de communication ; et
- de moyens de commande susceptibles d'être actionnés par un opérateur et comportant des moyens de sélection et activation d'une valeur de communication pour l'émission, des moyens de sélection et activation de plusieurs valeurs de communication pour la réception et des moyens de saisie d'une valeur de communication,
est remarquable en ce que lesdits moyens d'affichage sont susceptibles de présenter sur ledit écran de visualisation au moins deux valeurs de communication qui ont été sélectionnées et activées par l'intermédiaire desdits moyens de commande, en ce que lesdits moyens d'affichage sont formés de manière à toujours présenter, de façon automatique, sur ledit écran de visualisation la valeur de communication qui a été sélectionnée et activée pour l'émission cette valeur de communication étant mise en évidence sur ledit boîtier, et en ce que lesdits moyens de commande comportent de plus, sur ledit boîtier, des moyens de mixage susceptibles d'être actionnés par un opérateur et permettant à ce dernier de mixer toutes les valeurs de communication qui ont été sélectionnées et activées, en réglant les volumes individuels.

Ainsi, grâce à l'invention, les moyens de commande (sélection et activation) des valeurs de communication (fréquences radioélectriques et/ou numéros de téléphone) et les moyens de mixage (c'est-à-dire de réglage du volume sonore) sont situés sur le même boîtier, ce qui évite les va-et-vient précités entre différents dispositifs et permet à l'opérateur (pilote, copilote, ...) de réaliser un contrôle simple, rapide, précis et maîtrisé de ses communications audio.

De plus, et surtout, grâce à l'invention, l'opérateur sait toujours quelle est la valeur de communication (notamment la fréquence radioélectrique) qui est activée pour l'émission de sorte que le risque qu'il réalise des dérèglements intempestifs d'autres valeurs de communication par défaut d'information, n'existe plus.

Le dispositif de commande conforme à l'invention facilite donc la réalisation et la compréhension des différentes commandes et permet de remédier aux inconvénients précités.

Selon l'invention :
- au moins l'un desdits canaux de communication est un canal de radiocommunication du type précité et lesdites valeurs de communication (dudit canal de communication) sont des fréquences radioélectriques ; et/ou
- au moins l'un desdits canaux de communication est un canal de téléphone, par exemple du réseau SATCOM précité, et lesdites valeurs de communication (dudit canal de communication) sont des numéros de téléphone.

Pour faciliter le repérage de la valeur de communication, et notamment de la fréquence radioélectrique, qui est activée en émission :
- lesdits moyens d'affichage mettent en évidence sur l'écran de visualisation la valeur de communication activée en émission ; et/ou
- lesdits moyens de commande comportent une pluralité d'éléments de réglage, dont chacun est destiné à sélectionner et activer en émission un canal de communication particulier, et comporte un voyant lumineux, et lesdits moyens de commande commandent lesdits voyants lumineux de manière à activer le voyant lumineux relatif au canal de communication qui est sélectionné et activé en émission.

En outre, avantageusement, lesdits moyens d'affichage présentent sur ledit écran de visualisation, respectivement sur des zones de visualisation différentes, les valeurs de communication qui ont été sélectionnées et activées par l'intermédiaire des moyens de commande, pour au moins certains desdits canaux de communication.

Par ailleurs, de façon avantageuse, pour informer précisément les opérateurs du volume sonore effectif de chacune des différentes valeurs de communication (notamment des fréquences radioélectriques) qui sont activées :
- lesdits moyens d'affichage présentent sur l'écran de visualisation, pour chaque valeur de communication qui est présentée sur ledit écran de visualisation, un indicateur (de volume sonore), qui indique le volume sonore de la valeur de communication correspondante et/ou qui indique si la valeur de communication correspondante est sélectionnée en réception ; et/ou
- lesdits moyens de mixage comportent une pluralité d'éléments de réglage, dont chacun est destiné à sélectionner la réception et régler le volume sonore d'un canal de communication particulier, et chacun desdits éléments de réglage comporte un repère, permettant d'indiquer le volume sonore correspondant.

Par ailleurs, dans un mode de réalisation particulier, le dispositif de commande conforme à l'invention comporte de plus :
- des moyens de stockage comprenant au moins une liste d'au moins une valeur de communication, qui est susceptible d'être présentée sur ledit écran de visualisation par les moyens d'affichage ;
- des moyens d'appel susceptibles d'être actionnés par un opérateur et permettant à ce dernier d'appeler ladite liste de sorte qu'elle soit présentée sur ledit écran de visualisation ; et
- des moyens de sélection susceptibles d'être actionnés par un opérateur et permettant à ce dernier de sélectionner une valeur de communication de la liste qui est présentée sur l'écran de visualisation.

Ce mode de réalisation particulier permet de réaliser des gains de temps [en anticipant la saisie de plusieurs fréquences (ou numéros de téléphone) utiles et en réduisant le temps nécessaire à la sélection de fréquence aux moments appropriés de changement de fréquence] et d'éviter des erreurs de saisie.

De plus, avantageusement, ledit dispositif de commande comporte également un moyen pouvant être amovible, qui est susceptible d'être relié, par l'intermédiaire d'une liaison numérique, auxdits moyens de stockage pour charger automatiquement au moins une liste de valeurs de communication dans lesdits moyens de stockage, ce qui facilite et rend plus sûr le chargement de valeurs de communication et, de plus, permet le chargement simultané d'une pluralité de telles valeurs.

Par ailleurs, selon l'invention, ledit dispositif de commande comporte de plus :
- des moyens, par exemple un clavier et/un ensemble d'éléments rotatifs, pour régler les valeurs de communication ; et/ou
- des moyens (touches, molette, ...) pour déplacer sur l'écran de visualisation un signe particulier permettant de choisir, parmi les valeurs de communication qui sont présentées sur ledit écran de visualisation, celle que l'on souhaite régler.

La présente invention concerne également un système de communication, comportant notamment :
- une pluralité d'équipements de communication (émetteurs, récepteurs, ...) permettant d'engendrer une communication en émission et en réception par l'intermédiaire de valeurs de communication sur des canaux de communication ;
- des moyens de communication audio [haut-parleur(s), microphone(s), ...] ; et
- un dispositif de commande.

Selon l'invention, ce système de communication est remarquable en ce que ledit dispositif de commande est tel que celui précité.

Les figures du dessin annexé feront bien comprendre comment l'invention peut être réalisée. Sur ces figures, des références identiques désignent des éléments semblables.

La figure 1 est le schéma synoptique d'un système de communication qui est muni d'un dispositif de commande conforme à l'invention.

La figure 2 montre schématiquement un exemple de réalisation d'un dispositif de commande conforme à l'invention.

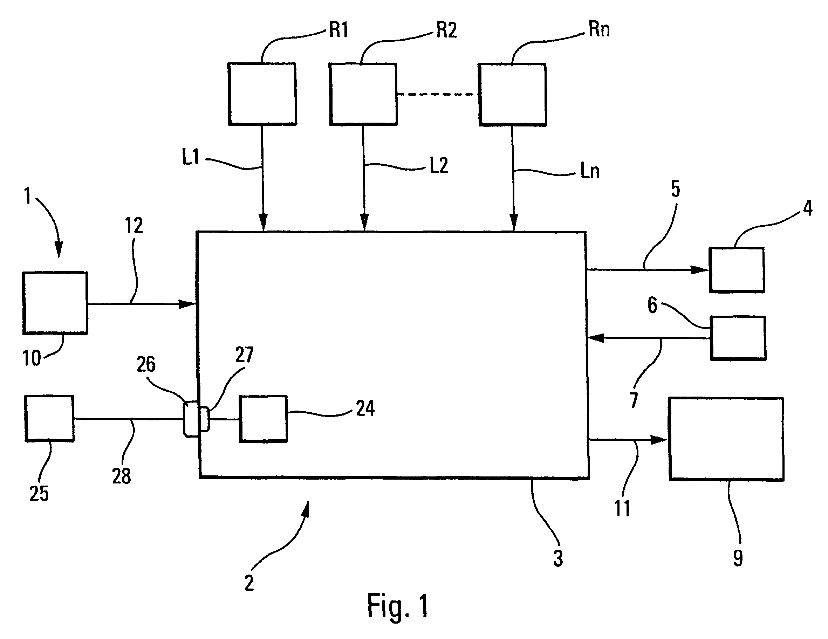

Le dispositif de commande 1 conforme à l'invention est destiné à commander un système de communication 2 représenté schématiquement sur la figure 1, qui est embarqué sur un aéronef, notamment un avion de transport civil, non représenté.

Un tel système de communication 2 permet de mettre en oeuvre et de contrôler, de façon usuelle, les communications audio à bord de l'aéronef. Ces communications audio sont toutes celles que les pilotes de l'aéronef peuvent avoir, en particulier avec le contrôle aérien (par l'intermédiaire de canaux VHF ["Very High Frequency" : canaux à très hautes fréquences] ou de canaux HF ["High Frequency" : canaux à hautes fréquences] par exemple), avec les compagnies aériennes (par l'intermédiaire d'une liaison téléphonique, par exemple sur le réseau "SATCOM"), ... Ces communications peuvent également concerner celles d'autres interlocuteurs de l'aéronef, tels que les membres d'équipage ou les passagers.

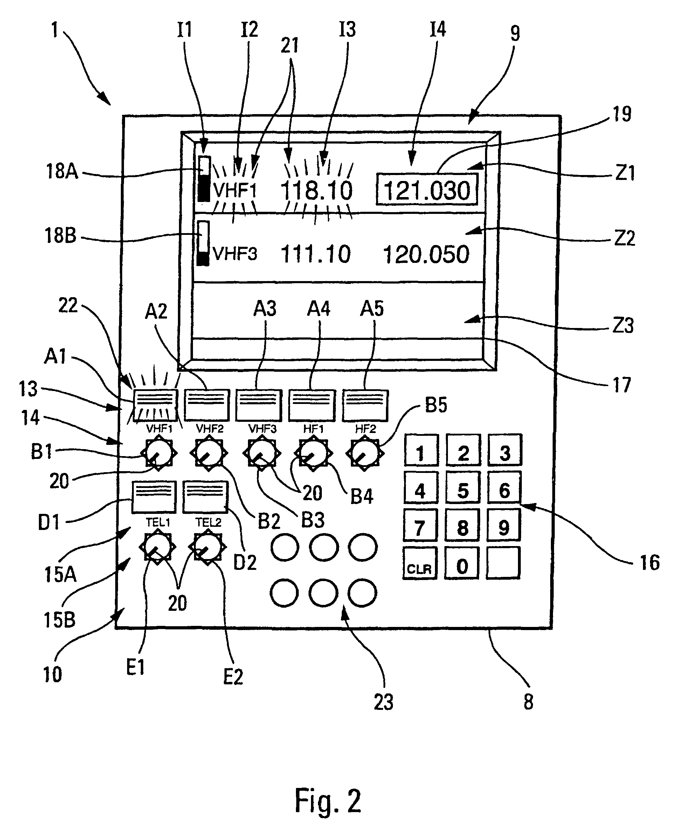

Ce système de communication 2 comporte de façon connue et générale :
- une unité centrale 3 ;
- des moyens de communication R1, R2, ..., Rn, de type usuel, reliés respectivement par des liaisons L1, L2, ..., Ln à l'unité centrale 3 et permettant d'engendrer une communication en émission et en réception par l'intermédiaire de valeurs de communication. Dans le cadre de la présente invention, on entend par valeur de communication soit une fréquence radioélectrique précisée ci-dessous, soit un numéro de téléphone également précisé ci-dessous. Ces moyens de communication R1 à Rn comportent notamment des émetteurs et des récepteurs, travaillant respectivement en émission et en réception sur des valeurs de communication appartenant à des canaux de communication particuliers du type précité ;
- au moins un haut-parleur 4 qui est relié par une liaison 5 à l'unité centrale 3 ;
- au moins un microphone 6 qui est relié par une liaison 7 à l'unité centrale 3 ; et
- ledit dispositif de commande 1 représenté sur la figure 2 et comportant notamment, sur un unique boîtier 8, des moyens d'affichage 9 et des moyens de commande 10 qui sont reliés, respectivement par des liaisons 11 et 12, à l'unité centrale 3.

Selon l'invention, lesdits moyens de commande 10 sont agencés sur un panneau de commande unique et sont formés pour, à la fois :
- sélectionner et activer une seule valeur de communication en émission pour chaque type de valeur de communication (fréquence radioélectrique et numéro de téléphone), c'est-à-dire pour choisir une telle valeur de communication (fréquence radioélectrique, numéro de téléphone) et pour commander les moyens de communication R1 à Rn appropriés afin qu'ils réalisent une communication en émission ;
- sélectionner et activer simultanément plusieurs valeurs de communication (fréquences radioélectriques et/ou numéros de téléphone) en réception ; et
- mixer toutes les valeurs de communication qui sont activées.

Pour ce faire, lesdits moyens de commande 10 comportent :
- des moyens de sélection 13, 15A précisés ci-dessous, susceptibles d'être actionnés par un opérateur (pilote, copilote, ...) et permettant à ce dernier de sélectionner et d'activer pour l'émission une seule valeur de communication (fréquence radioélectrique, numéro de téléphone) ; et
- des moyens de mixage 14, 15B précisés ci-dessous, susceptibles d'être actionnés par un opérateur et permettant à ce dernier d'activer la réception et de mixer toutes les valeurs de communication qui ont été sélectionnées et activées, en réglant les volumes individuels.

De plus, selon l'invention, lesdits moyens d'affichage 9 sont susceptibles de présenter sur au moins un écran de visualisation 17 au moins deux valeurs de communication qui ont été sélectionnées et activées par l'intermédiaire desdits moyens de commande 10. Ces moyens d'affichage 9 sont de plus formés de manière à toujours présenter, de façon automatique, sur ledit écran de visualisation 17, le cas échéant la valeur de communication [fréquence radioélectrique (118.10) sur la figure 2] qui a été sélectionnée et activée pour l'émission, par l'intermédiaire desdits moyens de commande 10.

Ainsi, grâce à l'invention, les moyens de sélection et les moyens de mixage (c'est-à-dire activation et réglage du volume sonore) sont situés sur le même boîtier (ou même panneau de commande), ce qui évite les nombreux va-et-vient qui existent avec les dispositifs usuels et permet à l'opérateur (pilote, copilote) de réaliser un contrôle simple, rapide et précis de ses communications audio.

De plus, et surtout, grâce à l'invention, l'opérateur sait toujours quelle est la valeur de communication qui est activée pour l'émission. Ainsi, par exemple lors du réglage d'une fréquence radioélectrique pour l'émission, le risque que le pilote réalise des dérèglements intempestifs d'autres fréquences par défaut d'information, n'existe plus.

Selon l'invention, lesdits moyens de sélection comportent, comme représenté sur la figure 2 :
- lesdits moyens 13 qui comprennent des moyens A1 à A5, notamment des boutons-poussoirs, pour sélectionner un canal de radiocommunication parmi une pluralité de canaux disponibles (VHF1, VHF2, VHF3, HF1 et HF2 dans l'exemple de la figure 2) ;
- lesdits moyens 15A qui comportent des moyens D1, D2, notamment des boutons-poussoirs, pour sélectionner un canal de téléphone (TEL1, TEL2); et
- un ensemble 16 de touches ou un ensemble 23 (présenté schématiquement) de boutons rotatifs, pour saisir la valeur d'une nouvelle fréquence radioélectrique ou d'un nouveau numéro de téléphone. La valeur qui va être saisie est affichée à droite, tandis que celle qui a été saisie préalablement et qui est activée est affichée à gauche sur l'écran de visualisation 17.

Les moyens de mixage 14 comportent, quant à eux, notamment des moyens B1 à B5, en particulier des boutons rotatifs, qui sont associés respectivement auxdits moyens A1 et A5 et qui permettent à un opérateur de régler les volumes sonores respectivement des fréquences qui sont activées sur les canaux choisis par les moyens 13.

En outre, les moyens de mixage 15B comportent des boutons rotatifs E1, E2, qui sont associés respectivement aux deux canaux de téléphone précités (TEL1 et TEL2) du réseau SATCOM et qui permettent de régler les volumes sonores correspondants.

Par ailleurs, l'écran de visualisation 17 comporte différentes zones de visualisation Z1, Z2 et Z3. Les zones Z1 et Z2 sont destinées à indiquer au moins certaines des fréquences radioélectriques qui sont activées (dont la fréquence radioélectrique qui est activée pour l'émission) et la zone Z3 est destinée à indiquer le numéro de téléphone qui est éventuellement appelé, aucun numéro n'étant appelé sur l'exemple de la figure 2.

Chacune des zones Z1 et Z2 est associée à un seul et même canal de radiocommunication et comporte des plages d'information I1, I2, I3 et I4 différentes, comprenant respectivement, pour ce canal :
- un indicateur 18A, 18B de volume sonore et d'activation en réception ;
- le nom du canal (VHF1, VHF3);
- la fréquence qui est activée (118.10 et 111.10) exprimée en MHz ; et
- la fréquence en cours de saisie (121.030 et 120.50) également en MHz.

De plus, selon l'invention, lorsqu'une fréquence est en train d'être saisie, elle est mise en évidence par un signe particulier 19, par exemple un rectangle, comme représenté pour la fréquence de 121.030 MHz sur la zone Z1 de la figure 2. Les moyens de commande 10 comportent des moyens (touches, molette, ...), par exemple de l'ensemble 23, qui permettent de déplacer le signe particulier 19 afin de choisir la valeur de communication que l'on souhaite régler.

Les indicateurs de volume sonore 18A et 18B sont des barographes verticaux connus. Le volume sonore est traduit par le niveau de remplissage du barographe et la sélection du moyen en réception est traduite par la présence d'un barographe vide. Le volume sonore peut également être déduit à partir de la position d'un repère 20 qui est prévu sur chacun des boutons rotatifs B1 à B5, E1 et E2, par rapport à une position de référence non représentée.

Par ailleurs, pour faciliter le repérage de la valeur de communication qui est activée en émission, valeur qui selon l'invention est toujours affichée, cette dernière est mise en évidence sur le boîtier 8 :
- d'une part, par l'intermédiaire des moyens d'affichage 9, notamment par un changement d'apparence, par exemple par un changement de couleur ou une surbrillance au niveau des plages d'information 12 et 13 (nom du canal sélectionné et valeur numérique de la fréquence), comme cela est illustré par un signal 21 sur la figure 2 ; et
- d'autre part, par le déclenchement d'un voyant lumineux au niveau de la touche de sélection du canal d'émission, comme cela est illustré pour le bouton-poussoir A1 par un signal 22 sur la figure 2.

Chacun des boutons-poussoirs A1 à A5, D1 et D2 comporte un tel voyant lumineux non représenté, qui est de préférence intégré dans le bouton-poussoir associé.

Les moyens de commande 10 comportent, de plus, l'ensemble 23 d'éléments de commande (notamment les boutons rotatifs précités), qui sont usuels (touches, boutons, ...) et non décrits davantage.

Dans un mode de réalisation préféré, le dispositif de commande 1 conforme à l'invention comporte également :
- des moyens de stockage 24 de type usuel (une mémoire usuelle), comprenant au moins une liste de valeurs de communication (fréquences radioélectriques et/ou numéros de téléphone), qui est susceptible d'être présentée sur ledit écran de visualisation 17 par les moyens d'affichage 9. Cette liste peut être composée éventuellement d'une fréquence radioélectrique unique ou d'un numéro de téléphone unique ;
- des moyens d'appel, par exemple un élément de commande de l'ensemble 23, susceptibles d'être actionnés par un opérateur et permettant à ce dernier d'appeler ladite liste de sorte qu'elle soit présentée sur ledit écran de visualisation 17 ; et
- des moyens de sélection, par exemple un élément de commande de l'ensemble 23, susceptibles d'être actionnés par un opérateur et permettant à ce dernier de sélectionner au moins l'une des valeurs de communication de la liste qui est présentée sur l'écran de visualisation 17 (suite à un appel).

Ce mode de réalisation préféré permet de réaliser des gains de temps (en anticipant la saisie de plusieurs valeurs, notamment de fréquences, utiles et en réduisant le temps nécessaire à la sélection de valeur aux moments appropriés de changement de valeur) et d'éviter des erreurs de saisie.

De plus, pour faciliter le chargement d'une liste dans les moyens de stockage 24, le dispositif de commande 1 comporte de plus un moyen pouvant être amovible 25 de type usuel, qui est susceptible d'être relié (par l'intermédiaire d'un moyen de connexion 26 coopérant avec un moyen de connexion 27 desdits moyens de stockage 24) auxdits moyens de stockage 24, comme représenté sur la figure 1, pour charger automatiquement, par l'intermédiaire d'une liaison numérique 28, au moins une liste de fréquences dans lesdits moyens de stockage 24.

## Revendications

1. Dispositif de commande d'un système de communication (2) d'un aéronef contrôlant les communications audio d'au moins un opérateur dudit aéronef, notamment un avion de transport, ledit système de communication (2) engendrant une communication en émission et en réception par l'intermédiaire de valeurs de communication activables de canaux de communication, ledit dispositif de commande (1) comportant un boîtier (8) qui est muni :
- de moyens d'affichage (9) pour présenter sur au moins un écran de visualisation (17) au moins l'une desdites valeurs de communication ; et
- de moyens de commande (10) susceptibles d'être actionnés par un opérateur et comportant des moyens de sélection et activation d'une valeur de communication pour l'émission (13, 15A), des moyens de sélection et activation de plusieurs valeurs de communication pour la réception (14, 15B) et des moyens de saisie (16, 23) d'une valeur de communication,
ou lesdits moyens d'affichage (9) sont susceptibles de présenter sur ledit écran de visualisation (17) au moins deux valeurs de communication qui ont été sélectionnées et activées par l'intermédiaire desdits moyens de commande (10), **en ce que** lesdits moyens d'affichage (9) sont formés de manière à toujours présenter, de façon automatique, sur ledit écran de visualisation (17) la valeur de communication qui a été sélectionnée et activée pour l'émission cette valeur de communication étant mise en évidence sur ledit boîtier, et lesdits moyens de commande (10) comportent de plus, sur ledit boîtier (8), des moyens de mixage (14, 15B) susceptibles d'être actionnés par un opérateur et permettant à ce dernier de mixer toutes les valeurs de communication qui ont été sélectionnées et activées, en réglant les volumes individuels.

2. Dispositif selon la revendication 1,
**caractérisé en ce qu'**au moins l'un desdits canaux de communication est un canal de radiocommunication (VHF1, VHF2, VHF3, HF1, HF2) et lesdites valeurs de communication dudit canal de communication sont des fréquences radioélectriques.

3. Dispositif selon l'une des revendications 1 et 2,
**caractérisé en ce qu'**au moins l'un desdits canaux de communication est un canal de téléphone (TEL1, TEL2) et lesdites valeurs de communication dudit canal de communication sont des numéros de téléphone.

4. Dispositif de commande selon l'une des revendications 1 à 3,
**caractérisé en ce que** lesdits moyens d'affichage (9) présentent sur ledit écran de visualisation (17), respectivement sur des zones de visualisation (Z1, Z2, Z3) différentes, les valeurs de communication qui ont été sélectionnées et activées par l'intermédiaire des moyens de commande (10), pour au moins certains desdits canaux de communication (VHF1, VHF3).

5. Dispositif de commande selon l'une quelconque des revendication précédentes,
**caractérisé en ce que** lesdits moyens d'affichage (9) mettent en évidence (21) sur l'écran de visualisation (17) la valeur de communication activée pour l'émission, qui est présentée sur ledit écran de visualisation (17).

6. Dispositif de commande selon l'une quelconque des revendications précédentes,
**caractérisé en ce que** lesdits moyens de commande (10) comportent une pluralité d'éléments de réglage (A1 à A5, D1, D2), dont chacun est destiné à sélectionner et activer en émission un canal de communication particulier, et comporte un voyant lumineux, et **en ce que** lesdits moyens de commande (10) commandent lesdits voyants lumineux de manière à activer le voyant lumineux relatif au canal de communication qui est sélectionné et activé en émission.

7. Dispositif de commande selon l'une quelconque des revendications précédentes,
**caractérisé en ce que** lesdits moyens d'affichage (9) présentent sur l'écran de visualisation (17), pour chaque valeur de communication qui est présentée sur ledit écran de visualisation (17), un indicateur de volume sonore (18A, 18B) qui indique le volume sonore de la valeur de communication correspondante.

8. Dispositif de commande selon l'une quelconque des revendications précédentes,
**caractérisé en ce que** lesdits moyens d'affichage (9) présentent sur l'écran de visualisation (17), pour chaque valeur de communication qui est présentée sur ledit écran de visualisation (17), un indicateur (18A, 18B) qui indique si la valeur de communication correspondante est sélectionnée en réception.

9. Dispositif de commande selon l'une quelconque des revendications précédentes,
**caractérisé en ce que** lesdits moyens de mixage (14, 15B) comportent une pluralité d'éléments de réglage (B1 à B5, E1, E2), dont chacun est destiné à sélectionner la réception et régler le volume sonore d'un canal de communication particulier, et **en ce que** chacun desdits éléments de réglage (B1 à B5, E1, E2) comporte un repère (20), permettant d'indiquer le volume sonore correspondant.

10. Dispositif de commande selon l'une quelconque des revendications précédentes,
**caractérisé en ce qu'**il comporte de plus :
- des moyens de stockage (24) comprenant au moins une liste d'au moins une valeur de communication, qui est susceptible d'être présentée sur ledit écran de visualisation (17) par les moyens d'affichage (9) ;
- des moyens d'appel (23) susceptibles d'être actionnés par un opérateur et permettant à ce dernier d'appeler ladite liste de sorte qu'elle soit présentée sur ledit écran de visualisation (17) ; et
- des moyens de sélection (23) susceptibles d'être actionnés par un opérateur et permettant à ce dernier de sélectionner une valeur de communication de la liste qui est présentée sur l'écran de visualisation (17).

11. Dispositif de commande selon la revendication 10,
**caractérisé en ce qu'**il comporte de plus un moyen (25) susceptible d'être relié, par l'intermédiaire d'une liaison numérique (28), auxdits moyens de stockage (24) pour charger automatiquement au moins une liste de valeurs de communication dans lesdits moyens de stockage (24).

12. Dispositif selon l'une quelconque des revendications précédentes,
**caractérisé en ce qu'**il comporte de plus des moyens (16, 23) pour régler les valeurs de communication.

13. Dispositif selon l'une quelconque des revendications précédentes,
**caractérisé en ce qu'**il comporte de plus des moyens pour déplacer sur l'écran de visualisation (17) un signe particulier (19) permettant de choisir, parmi les valeurs de communication qui sont présentées sur ledit écran de visualisation (17), celle que l'on souhaite régler.

14. Système de communication, comportant notamment :
- une pluralité d'équipements de communication (R1 à Rn) permettant d'engendrer une communication en émission et en réception par l'intermédiaire de valeurs de communication sur des canaux de communication ;
- des moyens de communication audio (4, 6) ; et
- un dispositif de commande (1),
**caractérisé en ce que** ledit dispositif de commande (1) est tel que celui spécifié sous l'une quelconque des revendications 1 à 13.

## Patentansprüche

1. Kommunikationssystemsteuerungsvorrichtung (2) für ein Flugzeug zur Steuerung der Audiokommunikationen von mindestens einem Funker des Flugzeugs, namentlich eines Passagierflugzeugs, wobei das Kommunikationssystem (2) mit Hilfe von aktivierbaren Kommunikationswerten von Kommunikationskanälen eine Sende- und Empfangskommunikation herstellt, und wobei die Steuerungsvorrichtung (1) ein Gehäuse (8) aufweist, das mit den folgenden Vorrichtungen ausgestattet ist:
- Anzeigevorrichtungen (9) zur Darstellung von mindestens einem der Kommunikationswerte auf mindestens einem Bildschirm (17); und
- Steuermittel (10), die sich von einem Funker betätigen lassen und Vorrichtungen zur Wahl und zur Aktivierung eines Sende-Kommunikationswerts (13, 15A), Vorrichtungen zur Wahl und zur Aktivierung mehrerer Empfangs-Kommunikationswerte (14, 15B) sowie Vorrichtungen zur Eingabe (16, 23) eines Kommunikationswerts aufweisen,
wobei die Anzeigevorrichtungen (9) geeignet sind, um auf dem Bildschirm (17) mindestens zwei Kommunikationswerte anzuzeigen, die mit Hilfe der Steuermittel (10) gewählt und aktiviert worden sind, die Anzeigevorrichtungen (9) so ausgestaltet sind, dass sie stets automatisch auf dem Bildschirm (17) den Kommunikationswert darstellen, der zum Senden gewählt und aktiviert worden ist, wobei dieser Kommunikationswert auf dem Gehäuse besonders hervorgehoben wird, und die Steuermittel (10) weisen des Weiteren auf dem Gehäuse (8) Mischvorrichtungen (14, 15B) auf, die sich von einem Funker betätigen lassen und es diesem erlauben, alle Kommunikationswerte, die ausgewählt und aktiviert worden sind, zu mischen, wobei er die Lautstärken individuell einstellt.

2. Vorrichtung gemäß Anspruch 1,
**dadurch gekennzeichnet, dass** mindestens einer der Kommunikationskanäle ein Funkkanal ist (VHF1, VHF2, VHF3, HF1, HF2) und die Kommunikationswerte des Kommunikationskanals Funkfrequenzen sind.

3. Vorrichtung gemäß einem der Ansprüche 1 und 2,
**dadurch gekennzeichnet, dass** mindestens einer der Kommunikationskanäle ein Telefonkanal ist (TEL1, TEL2) und die Kommunikationswerte des Kommunikationskanals Telefonnummern sind.

4. Steuerungsvorrichtung gemäß einem der Ansprüche 1 bis 3,
**dadurch gekennzeichnet, dass** die Anzeigevorrichtungen (9) zumindest für einige der Kommimikationskanäle (VHF1, VHF3) auf dem Bildschirm (17) beziehungsweise in den verschiedenen Anzeigezonen (Z1, Z2, Z3) die Kommunikationswerte darstellen, die mit Hilfe der Steuermittel (10) gewählt und aktiviert worden sind.

5. Steuerungsvorrichtung gemäß einem der vorstehend genannten Ansprüche, **dadurch gekennzeichnet, dass** die Anzeigevorrichtungen (9) auf dem Bildschirm (17) den zum Senden aktivierten und auf dem Bildschirm (17) dargestellten Kommunikationswert besonders hervorheben (21).

6. Steuerungsvorrichtung gemaß einem der vorstehend genannten Ansprüche, **dadurch gekennzeichnet, dass** die Steuermittel (10) eine Vielzahl von Einstellelementen (A1 bis A5, D1, D2) aufweisen, die alle der Wahl und Aktivierung eines bestimmten Sende-Kommunikationskanals dienen und ein Funktionslämpchen aufweisen, und dass die Steuermittel (10) die Funktionslämpchen in der Weise steuern, dass diese in Relation mit dem Kommunikationskanal aktiviert werden, der zum Senden gewählt und aktiviert wird.

7. Steuerungsvorrichtung gemäß einem der vorstehend genannten Ansprüche, **dadurch gekennzeichnet, dass** die Anzeigevorrichtungen (9) auf dem Bildschirm (17) für jeden Kommunikationswert, der auf dem Bildschirm (17) dargestellt wird, eine Lautstärkeanzeige (18A, 18B) aufweisen, die die Lautstärke des entsprechenden Kommunikationswerts anzeigt.

8. Steuerungsvorrichtung gemäß einem der vorstehend genannten Ansprüche, **dadurch gekennzeichnet, dass** die Anzeigevorrichtungen (9) auf dem Bildschirm (17) für jeden Kommunikationswert, der auf dem Bildschirm (17) dargestellt wird, eine Anzeige (18A, 18B) aufweisen, die angibt, ob der entsprechende Empfangs-Kommunikationswert gewählt worden ist.

9. Steuerungsvorrichtung gemäß einem der vorstehend genannten Ansprüche, **dadurch gekennzeichnet, dass** die Mischvorrichtungen (14, 15B) eine Vielzahl von Einstellelementen (B1 bis B5, E1, E2) aufweisen, die alle der Empfangswahl und der Lautstärkeeinstellung eines bestimmten Kommunikationskanals dienen, und dass jedes der Einstellelemente (B1 bis B5, E1, E2) eine Markierung (20) aufweist, die es erlaubt, die entsprechende Lautstärke anzuzeigen.

10. Steuerungsvorrichtung gemäß einem der vorstehend genannten Ansprüche, **dadurch gekennzeichnet, dass** sie des Weiteren die folgenden Vorrichtungen aufweist:
- Speichervorrichtungen (24), die mindestens eine Liste mit mindestens einem Kommunikationswert aufweisen, die sich mittels der Anzeigevorrichtungen (9) auf dem Bildschirm (17) darstellen lässt;
- Rufvorrichtungen (23), die sich von einem Funker betätigen lassen und es diesem erlauben, die Liste aufzurufen, so dass sie auf dem Bildschirm (17) angezeigt wird; und
- Wahlvorrichtungen (23), die sich von einem Funker betätigen lassen und es diesem erlauben, aus der Liste, die auf dem Bildschirm (17) angezeigt wird, einen Kommunikationswert zu wählen.

11. Steuerungsvorrichtung gemäß Anspruch 10,
**dadurch gekennzeichnet, dass** sie des Weiteren eine Vorrichtung (25) aufweist, die sich mittels einer digitalen Verbindung (28) an die Speichervorrichtungen (24) anschließen lässt, um automatisch mindestens eine Liste mit Kommunikationswerten in die Speichervorrichtungen (24) zu laden.

12. Steuerungsvorrichtung gemäß einem der vorstehend genannten Ansprüche, **dadurch gekennzeichnet, dass** sie des Weiteren Vorrichtungen (16, 23) zur Einstellung der Kommunikationswerte aufweist.

13. Steuerungsvorrichtung gemäß einem der vorstehend genannten Ansprüche, **dadurch gekennzeichnet, dass** sie des Weiteren Vorrichtungen aufweist, um auf dem Bildschirm (17) ein bestimmtes Zeichen (19) zu verschieben, das es erlaubt, unter den Kommunikationswerten, die auf dem Bildschirm (17) dargestellt werden, den zu wählen, den man einstellen möchte.

14. Kommunikationssystem, das namentlich Folgendes aufweist:
- eine Vielzahl an Kommunikationsanlagen (R1 bis Rn), die es ermöglichen, mit Hilfe von Kommunikationswerten auf Kommunikationskanälen Sende- und Empfangskommunikationen herzustellen;
- Audio-Kommunikationsvorrichtungen (4, 6); und
- eine Steuerungsvorrichtung (1),
**dadurch gekennzeichnet, dass** die Steuerungsvorrichtung (1) so beschaffen ist, wie sie unter einem der Ansprüche 1 bis 13 beschrieben wird.

## Claims

1. A control device for a communication system (2) of an aircraft supervising the audio communications of at least one operator of said aircraft, in particular a transport plane, said communication system (2) effecting a communication in transmission and in reception by way of activatable values of communication of communication channels, said control device (1) comprising a box (8) which is furnished:
with display means (9) for depicting on at least one presentation screen (17) at least one of said communication values; and
- control means (10) capable of being actuated by an operator and comprising means of selection and activation of a communication value for transmission (13, 15A), means of selection and activation of several communication values for reception (14, 15B) and means of input (16, 23) of a communication value,
wherein said display means (9) are capable of depicting on said presentation screen (17) at least two communication values which have been selected and activated by way of said control means (10), wherein said display means (9) are formed in such a way as always to depict, automatically, on said presentation screen (17) the communication value which has been selected and activated for the transmission, this communication value being highlighted on said box, and said control means (10) furthermore comprise, on said box (8), mixing means (14, 15B) capable of being actuated by an operator and allowing the latter to mix all the communication values which have been selected and activated, by adjusting the individual volumes.

2. The device as claimed in claim 1,
**characterized in that** at least one of said communication channels is a radiocommunication channel (VHF1, VHF2, VHF3, HF1, HF2) and said communication values of said communication channel are radio frequencies.

3. The device as claimed in either of claims 1 and 2,
**characterized in that** at least one of said communication channels is a telephone channel (TEL1, TEL2) and said communication values of said communication channel are telephone numbers.

4. The control device as claimed in one of claims 1 to 3,
**characterized in that** said display means (9) depict on said presentation screen (17), respectively on different presentation zones (Z1, Z2, Z3), the communication values which have been selected and activated by way of the control means (10), for at least some of said communication channels (VHF1, VHF3).

5. The control device as claimed in any one of the preceding claims,
**characterized in that** said display means (9) highlight (21) on the presentation screen (17), the communication value activated for the transmission, which is depicted on said presentation screen (17).

6. The control device as claimed in any one of the preceding claims,
**characterized in that** said control means (10) comprise a plurality of adjustment elements (A1 to A5, D1, D2), each of which is intended for selecting and activating in transmission a particular communication channel, and comprises a light, and wherein said control means (10) control said lights in such a way as to activate the light relating to the communication channel which is selected and activated in transmission.

7. The control device as claimed in any one of the preceding claims,
**characterized in that** said display means (9) depict on the presentation screen (17), for each communication value which is depicted on said presentation screen (17), a sound volume indicator (18A, 18B) which indicates the sound volume of the corresponding communication value.

8. The control device as claimed in any one of the preceding claims,
**characterized in that** said display means (9) depict on the presentation screen (17), for each communication value which is depicted on said presentation screen (17), an indicator (18A, 18B) which indicates whether the corresponding communication value is selected in reception.

9. The control device as claimed in any one of the preceding claims,
**characterized in that** said mixing means (14, 15B) comprise a plurality of adjustment elements (B1 to B5, E1, E2), each of which is intended for selecting reception and for adjusting the sound volume of a particular communication channel, and wherein each of said adjustment elements (B1 to B5, E1, E2) comprises a tag (20), making it possible to indicate the corresponding sound volume.

10. The control device as claimed in any one of the preceding claims,
**characterized in that** it furthermore comprises:
- storage means (24) comprising at least one list of at least one communication value, which is capable of being depicted on said presentation screen (17) by the display means (9);
- call means (23) capable of being actuated by an operator and allowing the latter to call said list so that it is depicted on said presentation screen (17); and
- selection means (23) capable of being actuated by an operator and allowing the latter to select a communication value from the list which is depicted on the presentation screen (17).

11. The control device as claimed in claim 10,
**characterized in that** it furthermore comprises a means (25) capable of being connected, by way of a digital link (28), to said storage means (24) so as to automatically load at least one list of communication values into said storage means (24).

12. The device as claimed in any one of the preceding claims,
**characterized in that** it furthermore comprises means (16, 23) for adjusting the communication values.

13. The device as claimed in any one of the preceding claims,
**characterized in that** it furthermore comprises means for displacing a particular sign (19) over the presentation screen (17), making it possible to choose, from among the communication values which are depicted on said presentation screen (17), the one which one wishes to adjust.

14. A communication system, comprising in particular:
- a plurality of items of communication equipment (R1 to Rn) making it possible to effect a communication in transmission and in reception by way of communication values on communication channels;
- means of audio communication (4, 6); and
- a control device (1),
**characterized in that** said control device (1) is such as that specified under any one of claims 1 to 13.
